Europäisches Patentamt

European Patent Office

Office européen des brevets

(11) Numéro de publication: **0 032 551**
**A1**

(12) **DEMANDE DE BREVET EUROPEEN**

(21) Numéro de dépôt: **80107639.9**

(22) Date de dépôt: **04.12.80**

(51) Int. Cl.³: **H 03 F 3/45,** G 01 R 17/06

(30) Priorité: **09.01.80 FR 8000750**

(43) Date de publication de la demande: **29.07.81**
**Bulletin 81/30**

(84) Etats contractants désignés: **DE FR GB**

(71) Demandeur: **International Business Machines Corporation, Armonk, N.Y. 10504 (US)**

(72) Inventeur: **Hornung, Robert, 4, rue de Sévres, F-91540 Mennecy (FR)**
Inventeur: **Lebesnerais, Gérard, 9, rue des Près Saint Germain sur Ecole, F-77930 Perthes en Gatinais (FR)**

(74) Mandataire: **Klein, Daniel, COMPAGNIE IBM FRANCE Département de Propriété Industrielle, F-06610 La Gaude (FR)**

(54) **Procédé de compensation de la tension de décalage d'un amplificateur différentiel et macro fonctionnelle en résultant.**

㊼ La présente invention concerne une macro-fonction-nelle qui comporte un compteur-décompteur de cinq bits dont les sorties attaquent symétriquement deux convertisseurs numérique-analogique (CNA) de quatre bits. Le CNA1 est attaqué par les sorties $\bar{Q}$ montées en ET câblé avec la sortie Q du MSB (bit le plus significatif) inversée dans la porte A, le CNA2 est identique au CNA1, mais comporte en outre une cinquième cellule (non représentée) commandée par la porte C qui lui assure un LSB (bit le moins significatif) supplémentaire. Le CNA2 est attaqué par les sorties Q montées en ET câblé avec la sortie $\bar{Q}$ du MSB inversée dans la porte B. Les courants de sortie i1 et i2 obéissent à la relation $i1 + i2 = i = $ constante. Cette macro peut être avantageusement réalisée en technologie MTL (Merged Transistor Logic). La présente invention concerne également un procédé de compensation de la tension de décalage d'un amplificateur différentiel, en disposant cette macro dans la boucle de compensation, commandée par un comparateur, dont une entrée est une tension de référence et l'autre entrée est reliée à la sortie de l'amplificateur. Le compteur étant synchronisé par une horloge.

PROCEDE DE COMPENSATION DE LA TENSION DE
DECALAGE D'UN AMPLIFICATEUR DIFFERENTIEL
ET MACRO FONCTIONNELLE EN RESULTANT

## Description

### Domaine Technique

La présente invention concerne le domaine des amplificateurs différentiels (notamment des amplificateurs opérationnels) et plus particulièrement la correction de la tension de décalage de ces amplificateurs. Elle concerne également une macro fonctionnelle faisant office de convertisseur numérique-analogique.

### Etat de la Technique

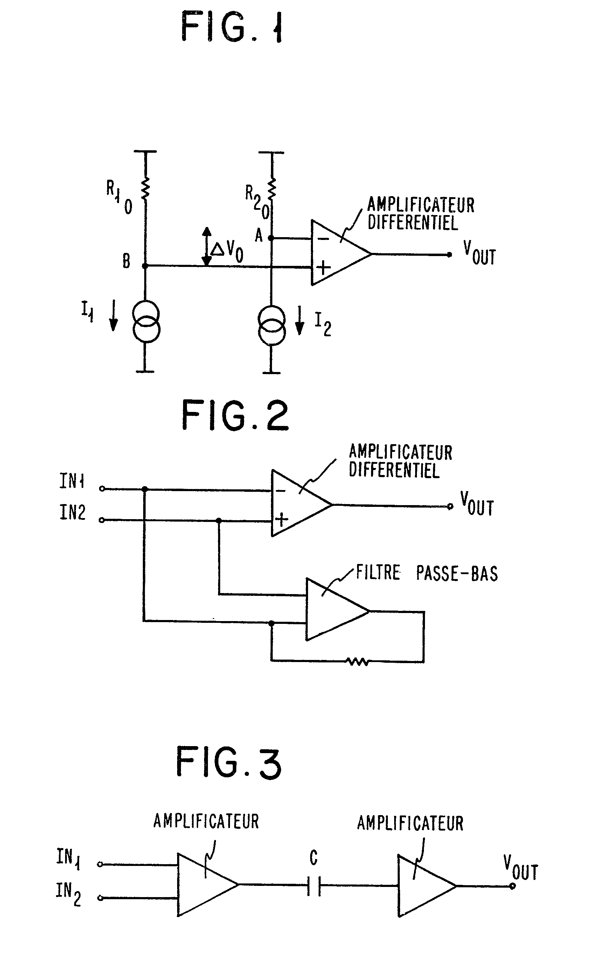

Dans certains cas l'information ou la donnée d'entrée d'un circuit est en fait constituée par la valeur d'une résistance. C'est le cas en particulier des circuits de lecture des mémoires à bulles magnétiques. La présence ou l'absence d'une bulle à un emplacement déterminé se traduit par un changement dans la valeur de deux résistances R1, R2 qui lui sont associées. En présence d'une bulle le couple (R1, R2) aura une première valeur (R1S, R2S), en l'absence de bulle, le couple aura une seconde valeur (R10, R20). La détection de l'état présence (ou absence) de la bulle s'effectue simplement en faisant passer un courant dans chacune des résistances R1 et R2 et en mesurant la différence des chutes de potentiel $V_E = R1S.I1 - R2S.I2$ dans un amplificateur différentiel (voir figure 1). En fait, on choisit pour des résistances de valeur égale, R, mais en réalité, en raison des techniques de fabrication, les résistances obtenues ont des valeurs différentes de la valeur nominale prévue R, qui correspondent à ces valeurs R1 et R2.

En l'absence de signal d'entrée $V_E$ (cas de l'absence d'une bulle) on a une tension de décalage à l'entrée $\Delta V_0$ (qui sera

explicitée plus loin) telle que $\Delta V_0$ = R10I1 - R20I2, R10 et R20 étant les valeurs des résistances R1 et R2 en l'absence de signal.

Ce circuit a alors l'avantage d'être complètement symétrique, ce qui permet la compensation de l'influence du courant d'entrée ainsi que des dérives en température des résistances. Il permet également de compenser les effets de bruit générés par les variations de tension rapides et les capacités parasites ($V_{BRUIT}$ = RC dV/dt) .

Le problème majeur lié à ce type de circuit est l'importante tension de décalage apparaissant entre les deux entrées de l'amplificateur. Cette tension est produite par les différences statistiques qui apparaissent en réalité lors de la fabrication des résistances et qui conduisent à ces valeurs R1 et R2, que l'on souhaiterait égales. Il en est de même pour I1 et I2. Pour certains calculs approximatifs, on peut cependant admettre R1=R2=R et I1=I2=I. Cette tension de décalage est suffisamment importante pour qu'un ajustage soit nécessaire.

L'ajustage par potentiomètre est certe possible dans certains cas mais est une solution chére et peu fiable.

L'ajustage par la technique dite: "active trimming" n'est pas possible dans le cas où les résistances R1 et R2 sont extérieures aux circuits. Il faut donc utiliser une méthode de compensation dynamique de la tension de décalage. Une méthode de compensation connue sous le nom de stabilisation par "chopper" permet de compenser la tension de décalage. On pourra se référer par exemple à l'ouvrage classique "Operational Amplifier Design and Applications" par Burr-Brown, Mc Graw-Hill, pages 150 à 164. Le principe de cette technique est de séparer la composante continue au moyen d'un amplificateur basse-fréquence. Une représentation équivalente pour le cas d'un amplificateur différentiel est montrée sur la figure 2. L'amplificateur basse-fréquences doit avoir une fréquence de coupure de l'ordre de quelques kilohertz, ce qui implique l'utilisation de capacités relativement élevées (30-50 picofarads). Or les capacités que l'on peut faire dans les circuits monolithiques sont très rapidement limitées en valeur car elles consomment alors trop de surface et en outre elles diminuent de façon sensible le rendement de fabrication. Un autre inconvénient est l'augmentation des capacités sur chaque entrée d'amplificateur et la non symétrie pour ces mêmes entrées.

Encore une autre méthode de compensation possible est montrée sur la figure 3. L'amplificateur d'entrée a un gain suffisamment faible pour qu'il fonctionne dans la zone linéaire, quelle que soit la tension de décalage à l'entrée; c'est-à-dire que le produit du gain par la tension de décalage est inférieur à la tension maximale admissible à la sortie de cet amplificateur. La composante continue est alors supprimée par la capacité C et la composante alternative amplifiée par le second amplificateur. Cette approche a pour inconvénient le faible gain de l'étage d'entrée en plus du problème posé par la capacité déjà mentionnée. En effet le taux de réjection en mode commun est proportionnel au gain de l'amplificateur et lorsque la tension de décalage d'entrée est grande, le gain doit être faible (2 à 5).

Exposé de l'Invention

La présente invention concerne un procédé de correction de la tension de décalage d'un amplificateur différentiel dont les entrées + et − sont reliées à deux résistances R1 et R2 et à deux sources de courant I1 et I2 respectivement. Cet amplificateur est muni d'une boucle de réaction comportant un comparateur dont une entrée est liée à une tension de référence $V_{REF}$ et dont la sortie attaque un compteur-décompteur synchronisé par une horloge, ce dernier attaque un convertisseur numérique analogique (n bits) muni de deux sorties complémentaires fournissant les courants i1 et i2, tels que i1+i2 = constante, ces courants i1 et i2 commandent

0032551

lesdites sources de courant, procédé caractérisé en ce que le convertisseur numérique-analogique de n bits est remplacé par deux convertisseurs numérique-analogique de n-1 bits associés à des moyens complémentaires de commande. La présente invention concerne également la macro fonctionnelle composée de ces deux convertisseurs numérique-analogique de n-1 bits attaqués par le compteur-décompteur de n bits, avec lesdits moyens complémentaires de commande.

Les avantages portent sur la faisabilité d'une telle macro: un convertisseur numérique-analogique de n bits en technologie MTL peut être impossible sinon très difficile à réaliser (actuellement on peut admettre n=5), alors que deux convertisseurs numériques-analogiques de n-1 bits peuvent être réalisés plus facilement (c'est le cas pour n=4).

Il porte également sur le gain considérable de place que cette modification entraîne (un facteur trois environ).

D'autres objets, caractéristiques et avantages de la présente invention ressortiront mieux de l'exposé qui suit, fait en référence aux dessins annexés à ce texte, qui représentent un mode de réalisation préféré de celle-ci.

Brève Description
des Figures

La figure 1 représente le schéma du circuit électrique simplifié d'un amplificateur opérationel de lecture de bulles magnétiques réalisé à partir d'un amplificateur différentiel.

La figure 2 représente schématiquement une solution de l'art antérieur pour corriger la tension de décalage de l'amplificateur différentiel.

La figure 3 représente une autre solution de l'art antérieur pour corriger la tension de décalage de l'amplificateur différentiel.

La figure 4 représente encore une autre solution de l'art antérieur pour corriger la tension de décalage de l'amplificateur différentiel, mettant en oeuvre plus particulièrement un convertisseur numérique-analogique de n bits.

La figure 5 représente les diagrammes de tension et de courant aux différents points du circuit décrit sur la figure 4 pour deux modes différents de fonctionnement correspondants à $\Delta V_0 > 0$ et $\Delta V_0 < 0$.

La figure 6 représente la solution de la présente invention dans laquelle le convertisseur numérique analogique de n bits est remplacé par deux convertisseurs analogiques de n-1 bits.

La figure 7 représente le fonctionnement simplifié d'un convertisseur numérique-analogique de 4 bits en technologie MTL.

### Description de l'Invention

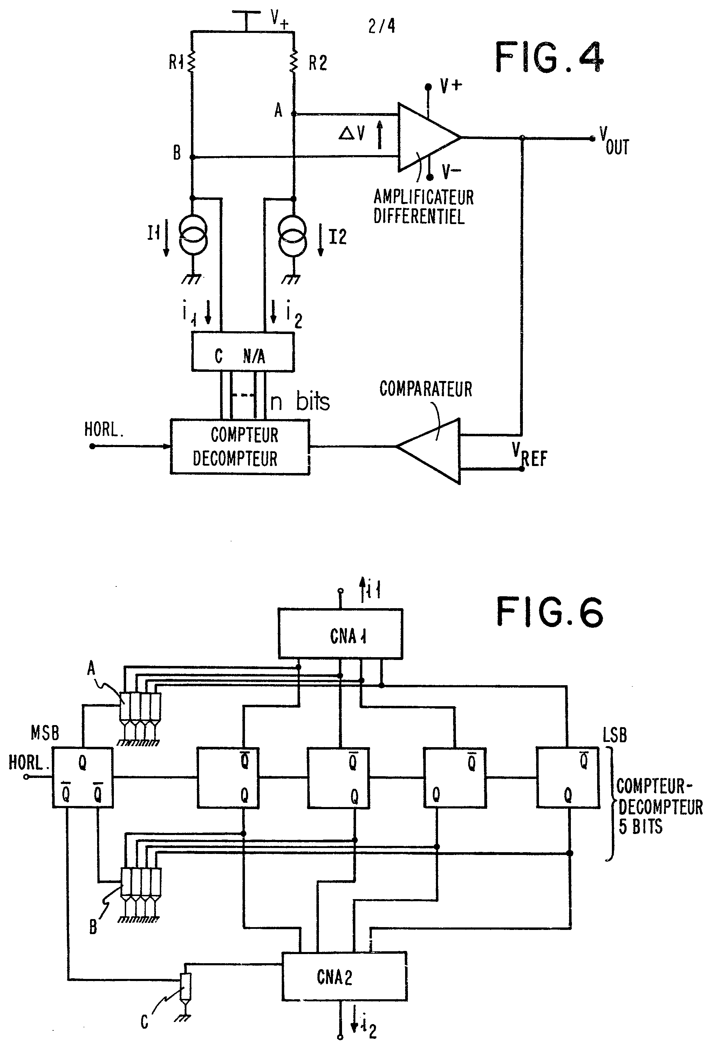

Un circuit connu de compensation de la tension de décalage est montré sur la figure 4.

L'étage d'entrée de ce circuit, composé des résistances R1 et R2 et des sources de courant I1 et I2 présente lorsqu' aucun signal n'est appliqué sur les entrées de l'amplificateur différentiel, une tension dite de décalage $\Delta V_0$ entre les points A et B ($\Delta V_0 = V_A - V_B$ quand $V_E = 0$). Rappelons que la présence d'une telle tension $\Delta V_0$ est principalement due:

- au fait que l'appairage entre les résistances R1 et R2 d'une part et les sources de courant I1 et I2 n'est pas parfait, en d'autres termes on ne peut pas obtenir I1=I2=I et R1=R2=R,

. à la dérive thermique des composants,

. à la tension de décalage de l'amplificateur lui-même, et enfin

. aux dérives dues au vieillissement.

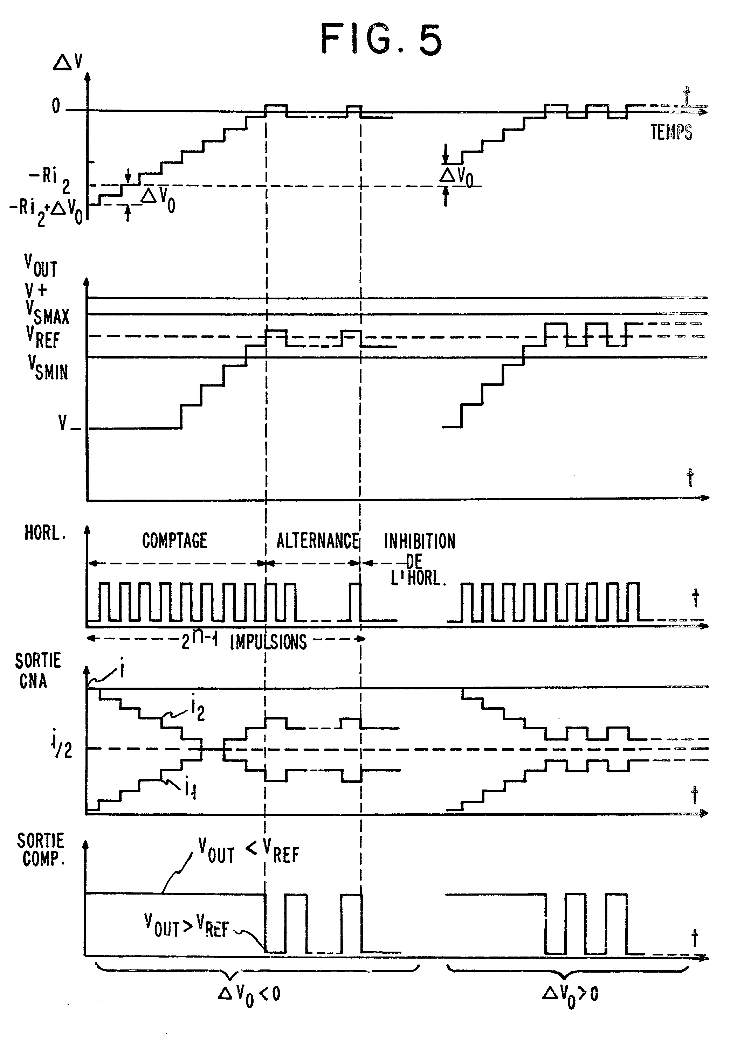

Le principe de la compensation, qui sera explicité à l'aide des figures 4 et 5, consiste à ramener la tension $\Delta V_0$ (qui peut être positive ou négative) existante lors de la mise sous tension du montage à une valeur telle que la tension de sortie $V_{out}$ de l'amplificateur différentiel reste dans une plage de tension de valeur centrale $V_{REF}$ et bornée par deux tensions appelées $V_{Smin}$ et $V_{Smax}$, soit $V_{Smin} < V_{out} < V_{Smax}$. En l'absence de signal d'entrée, il existe donc une tension de décalage $\Delta V_0$ à l'entrée de l'amplificateur différentiel qui produit $(V_{out})_0 = G\Delta V_0$ (G étant le gain de l'amplificateur, alimenté entre le V+ et le V-, par exemple +5V et -5V respectivement). On doit donc avoir le signal de sortie $(V_{out})_0 = G\Delta V_0$ tel que $V- < G\Delta V_0 < V+$ de façon à éviter la saturation de l'amplificateur et conserver une certaine marge de sécurité. Quand on applique un signal d'entrée $V_E$ on doit avoir pour les mêmes raisons

$$V- < G(\Delta V_0 + V_E) < V+ \ .$$

Si on appelle $V_{Smax} = V+ - GV_E$ et $V_{Smin} = V- + GV_E$, cette relation devient:

$$G \ |\Delta V_0| < V_{Smax}$$

quand

$$\Delta V_0 > 0 \text{ et } G \ |\Delta V_0| < -V_{Smin}$$

quand

$$\Delta V_0 < 0$$

Ces relations peuvent se combiner, soit

$$|\Delta V_0| \leq \frac{V_{Smax} - V_{Smin}}{2G}$$

Le circuit de compensation doit réaliser cette relation pour que l'on ait

$$V_{Smin} < V_{out} < V_{Smax}.$$

Concrètement, la compensation de la tension de décalage est réalisée au cours d'un cycle d'itération par la boucle de contre-réaction: comparateur, compteur-décompteur, convertisseur numérique-analogique (CNA). Chaque sortie du compteur-décompteur est reliée à une entrée du CNA. Durant le cycle d'itération, la tension de sortie $V_{out}$ est constamment comparée à la tension de référence $V_{REF}$ qui est donc en fait le milieu de l'amplitude de la tension de sortie linéaire de l'amplificateur. La réponse du comparateur détermine le mode de fonctionnement du compteur, c'est-à-dire comptage ou décomptage. Ce mode de fonctionnement est tel que les variations du contenu du compteur sont converties par le convertisseur CNA sous forme analogique en deux courants complémentaires i1 et i2, (tels que i1+i2=i), et qui modulent les sources de courant I1 et I2. Finalement ces courants entraînent la convergence des potentiels de A et de B l'un vers l'autre jusqu'à ce que $\Delta V = V_A - V_B$, ainsi que $V_{out}$ soient dans les limites spécifiées ci-dessus, notamment

$$|\Delta V_0| \leq \frac{V_{Smax} - V_{Smin}}{2G} \, .$$

Les diagrammes présentés sur la figure 5 illustrent bien les variations des principaux signaux électriques du montage lors du cycle de correction de la tension de décalage. Les deux cas considérés correspondent à deux tensions de décalage

de polarité opposée ($\Delta V_0 < 0$ et $\Delta V_0 > 0$) qui seraient présentes entre les points A et B en supposant que le dispositif de correction n'existe pas et qu'aucun signal $V_E$ ne soit appliqué entre ces points. Le fait d'adjoindre au montage la boucle de compensation et de supposer que le contenu du compteur soit à zéro en début de cycle implique que dans les deux cas:

- la valeur $\Delta V$ montrée sur le diagramme soit négative en début de cycle, en effet $\Delta V = \Delta V_0 - R2\ i2$ ($i2$ étant choisi de telle façon que

$$i2 > \frac{\Delta V_{0\ max}}{R2}$$

- alors seul le mode de comptage est utilisé jusqu'à ce que $V_{out}$ devienne plus grand que $V_{REF}$ à ce point le comparateur passe à l'état bas et le compteur passe en mode décomptage, c'est l'équilibre. La situation d'équilibre consistant (voir le diagramme) en une oscillation de la tension $V_{out}$ autour de $V_{REF}$ avec une amplitude $G \times R \times I_{LSB}$ ($I_{LSB}$ représente le courant du CNA représentatif du bit le moins significatif).

En effet le contenu du compteur étant 0, on a $i1 = 0$ et $i2 =$ courant maximum, donc le noeud A est au potentiel le plus bas et la tension de sortie $V_{out}$ est saturée dans les valeurs négatives aux environ de $V-$.

Pendant l'opération de comptage, le courant $i1$ croît pendant que le courant $i2$ décroît ($\Delta V$ est cependant toujours négatif), quand $V_{out} > V_{REF}$, le comparateur change d'état, le compteur décompte, on repasse à un état identique au précédent où $V_{out} < V_{REF}$ et l'on oscille autour de cette position d'équilibre.

Sachant que la remise à zéro (ou à un) du compteur n'est pas

0032551

obligatoire dans ce type de montage, on voit donc que le mode de fonctionnement du compteur durant le cycle dépend: de l'état initial du contenu du compteur à la mise sous tension et de la valeur qu'aurait eu la tension de décalage en faisant abstraction du circuit de correction ($\Delta V_0$). Dans tous les cas cependant, ce mode restera inchangé jusqu'à ce que la tension d'équilibre soit atteinte.

La valeur du LSB du convertisseur CNA: $I_{LSB}$, ainsi que la résolution du convertisseur (c'est-à-dire son nombre de bits) peuvent être déterminées simplement à partir des valeurs G, $V_{Smin}$, $V_{Smax}$ et de la valeur maximum $\pm\Delta V_{0max}$ que peut prendre la tension de décalage lorsqu'aucun signal n'est appliqué sur l'entrée. On aura en effet:

. la valeur du LSB est telle que

$$R.I_{LSB} \leq \frac{V_{Smax} - V_{Smin}}{2G}$$

. résolution n du convertisseur CNA (nombre de bits): la première valeur de n est telle que $2^n > k+1$.

avec $k = \dfrac{\Delta V_{0max}}{R.I_{LSB}}$

(k étant arrondi à l'entier supérieur).

La durée du cycle de compensation correspond au nombre d'impulsions d'horloge nécessaires à garantir la compensation de la tension de décalage maximum $\Delta V_{0max}$, c'est-à-dire $2^n-1$ impulsions, n étant le nombre de bits du compteur (et par conséquent du CNA). Une fois ce cycle terminé, l'horloge est inhibée et le signal d'entrée peut être alors amplifié par l'amplificateur différentiel. Ce signal d'entrée $V_E$ devra être tel que la tension de sortie $V_{out}$ reste dans les limites permises $V_{Smin}$ et $V_{Smax}$.

Ce qui limite l'intégration de ce circuit, c'est la complexité du compteur et du CNA comparés à celle de l'amplificateur différentiel. Cela explique pourquoi ce type de correction est extrêmement rare et n'est utilisé que lorsque l'on a épuisé toutes les autres techniques de corrections. C'est le cas de la présente application aux amplificateurs de lecture de bulles magnétiques, où l'ajustement doit se faire en présence du champ magnétique.

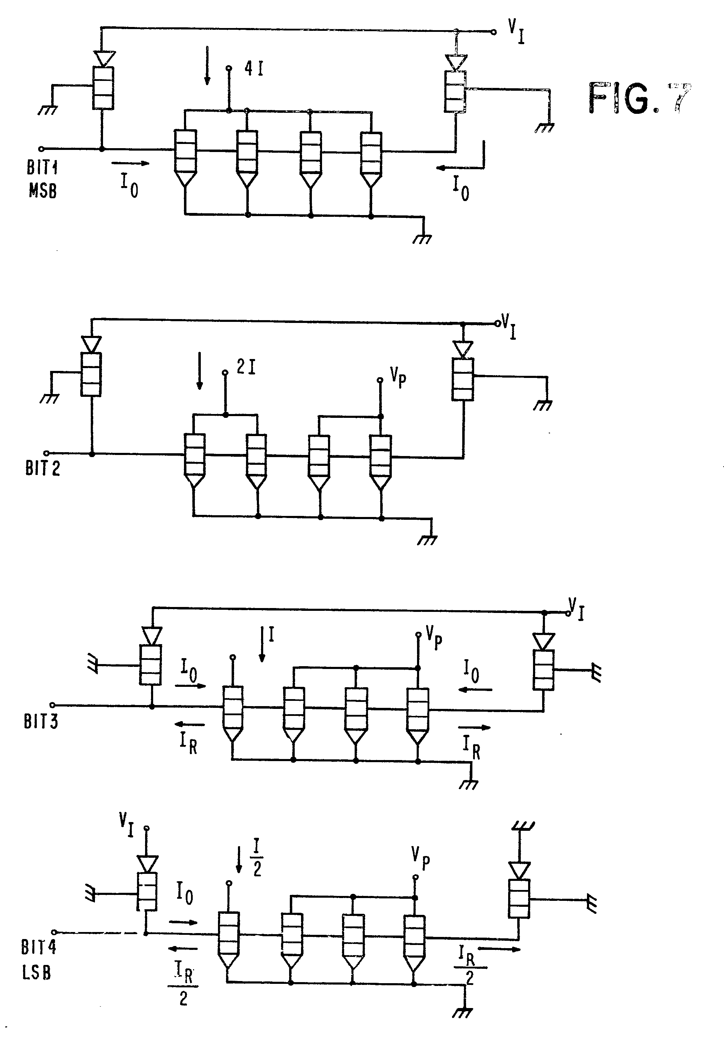

La solution proposée pour améliorer ce montage est montrée sur la figure 6. Elle consiste à remplacer le CNA de n bits décrit précédemment par un double convertisseur en technologie MTL (Merged Transistor Logic) de résolution (n-1) bits. Cette solution présente l'avantage de diviser par trois la place nécessaire sur la tranche de silicium, au convertisseur numérique-analogique.

Le principe de fonctionnement est le suivant.

Un des convertisseurs est destiné à transcrire la demi pleine échelle inférieure du compteur (c'est-à-dire de 0...0 à 1 1 .. 1), l'autre transcrivant la demi pleine échelle supérieure (c'est-à-dire 1 0 .. 0 à 1 ... 1). Le schéma de l'ensemble convertisseur plus compteur/décompteur est montré sur la figure 6 dans le cas d'un compteur cinq bits.

Le courant de sortie du convertisseur 1 correspond au courant i1, celui du convertisseur 2 au courant i2 du premier montage. On voit que l'inhibition de l'un des deux convertisseurs se fait très simplement en utilisant deux portes MTL, A et B dont les entrées sont respectivement le MSB (le bit le plus significatif) du compteur et son complément, et les sorties sont respectivement branchées en "ET câblé" sur les sorties complémentaires du compteur (c'est-à-dire aussi les entrées du convertisseur 1) et sur les sorties vraies du compteur (c'est-à-dire aussi les entrées du convertisseur 2). Quand les sorties du compteur sont à 00000, le CNA1 est pleine échelle, tandis que le CNA2 est bloqué. Quand le compteur compte jusqu'à 01111 (demi pleine échelle), le courant de sortie il du CNA1 diminue, le CNA2 reste bloqué parce que la porte B est activée. Cette porte B reste activée jusqu'à ce que le MSB devienne égal à 1, alors le CNA1 est bloqué à son tour parce que la porte A est alors activée.

Il est à noter que dans ce cas, si les courants pleine-échelle des CNA1 et CNA2 sont égaux à ceux de la figure 4, le $I_{LSB}$ de ces deux CNA est double puisque chaque CNA est maintenant utilisé uniquement pour une demi pleine échelle du compteur.

La table de vérité en annexe (TABLE I) donne l'état des entrées et des sorties du convertisseur numérique/analogique pour les états de sortie du compteur.

On s'aperçoit, en consultant les trois premières colonnes du tableau, qu'aux positions 01111 et 10000 du compteur est associée la même entrée 00000 aux convertisseurs 1 et 2. Cette situation conduit à avoir une position manquante que les sorties des convertisseurs lorsque l'on parcourt toute l'échelle de comptage du compteur. Cette omission est facilement réparée en ajoutant en permanence un $I_{LSB}$ (une unité de courant) au CNA2 lorsque celui-ci est en fonctionnement. En d'autres termes, le CNA2 a deux dispositifs LSB, l'un étant toujours en fonctionnement quand le CNA2 est activé (c'est-à-dire quand le MSB est présent).

La porte MTL C assure cette fonction.

Le détail de ces CNA1 et 2 est montré sur la figure 7. Chaque CNA 4 bits est constitué de 4 cellules MTL à quatre collecteurs. Chaque cellule MTL posséde deux injecteurs (les transistors PNP reliés à la tension $V_I$). De cette façon l'injection se fait depuis chaque extrémité de la base, et il y a moins de différence entre les courants des quatre collecteurs. Pour le MSB, les quatre collecteurs sont connectés à la sortie. Pour le deuxième bit seulement deux collecteurs sont connectés à la sortie, les deux autres étant présents et connectés à une tension positive quelconque Vp afin que cette cellule soit dans des conditions rigoureusement identiques à la précédente. Pour le troisième bit, un collecteur est connecté à la sortie, les trois sont connectés à Vp. Le quatrième bit est une cellule identique à la précédente, la seule différence étant qu'elle ne posséde qu'un seul injecteur connecté à $V_I$, l'autre est connectée à la masse pour des raisons de symétrie (afin de tenir compte du courant $I_R$ qui est réinjecté dans la base NPN dans l'injecteur. Le deuxième CNA posséde une cinquième cellule (non représentée) exactement identique à la cellule numéro 4 (LSB). Cette cinquième cellule est toujours activée lorsque le deuxième DAC est activé comme on l'a expliqué précédemment.

Ce type de montage devient très avantageux quand de la circuiterie logique de type MTL est disponible sur une tranche et ce pour deux raisons majeures:

. la réalisation d'un CNA 5 bits de type classique à l'aide de deux convertisseurs 4 bits de type MTL conduit on l'a vu à diviser la surface du convertisseur par trois;

. la réalisation du compteur/décompteur par des portes type MTL entraîne une compatibilité directe entre ce compteur et les convertisseurs (c'est-à-dire, pas de circuit d'interface à utiliser).

Une autre amélioration peut être apportée au premier montage qui a été discuté: c'est le positionnement du compteur/décompteur au milieu de sa pleine échelle (positions 01111 ou 10000) au début du cyle de la correction, ceci peut être réalisé sans adjonction d'une nouvelle circuiterie en jouant simplement sur la topologie des bascules MTL utilisées dans

le compteur-décompteur. Pour plus d'information on pourra se référer à la demande de brevet français No. 77 29967 déposée par la demanderesse le 28 septembre 1977.

Ce type d'initialisation aura pour effet de diviser par deux la durée du cycle de correction de la tension de décalage, puisque dans le pire des cas, une demi-pleine échelle sera parcourue.

Une autre amélioration possible et, en plus du positionnement à la moitié de la pleine échelle, d'inclure sur le même bloc, le circuit permettant de générer le nombre de coups d'horloge nécessaire pour parcourir la demi-pleine échelle. De cette façon, le circuit de compensation de la tension de décalage est entièrement invisible de l'extérieur. En effet, à la mise sous tension, on aurait automatiquement la séquence suivante

1. positionnement du compteur à 10000 (demi-pleine échelle)

2. Mise en route de l'horloge interne qui est envoyée sur l'horloge du compteur

3. Arrêt de l'horloge après le nombre de coups nécessaire.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite inven-tion.

TABLEAU I

— 1/2 pleine — échelle infér.

— 1/2 pleine — échelle supér.

| Compteur/ décompteur | MSB | Convertisseur 1 | Convertisseur 2 | Courants | | Porte MTL C |
|---|---|---|---|---|---|---|
| | | | | $i_1$ | $i_2$ | |
| 0 0 0 0 0 | 0 | 1 1 1 1 | 0 0 0 0 | 15 | 0 | 0 |
| 0 0 0 0 1 | 0 | 1 1 1 0 | 0 0 0 0 | 14 | 0 | 0 |
| 0 0 0 1 0 | 0 | 1 1 0 1 | 0 0 0 0 | 13 | 0 | 0 |
| · | · | · | · | · | · | · |
| · | · | · | · | · | · | · |
| · | · | · | · | · | · | · |
| 0 1 1 0 1 | 0 | 0 0 1 0 | 0 0 0 0 | 2 | 0 | 0 |
| 0 1 1 1 0 | 0 | 0 0 0 1 | 0 0 0 0 | 1 | 0 | 0 |
| 0 1 1 1 1 | 0 | 0 0 0 0 | 0 0 0 0 | 0 | 0 | 0 |
| 1 0 0 0 0 | 1 | 0 0 0 0 | 0 0 0 0 | 0 | 1 | 1 |
| 1 0 0 0 1 | · | 0 0 0 0 | 0 0 0 1 | 0 | 2 | 1 |
| 1 0 0 1 0 | · | 0 0 0 0 | 0 0 1 0 | 0 | 3 | 1 |
| · | · | · | · | · | · | · |
| · | · | · | · | · | · | · |
| · | · | · | · | · | · | · |
| 1 1 1 0 1 | · | 0 0 0 0 | 1 1 0 1 | 0 | 14 | 1 |
| 1 1 1 1 0 | · | 0 0 0 0 | 1 1 1 0 | 0 | 15 | 1 |
| 1 1 1 1 1 | 1 | 0 0 0 0 | 1 1 1 1 | 0 | 16 | 1 |

REVENDICATIONS

1. Dans un procédé de compensation de la tension de décalage d'un amplificateur opérationnel muni de deux générateurs de signal d'entrée dont la différence doit être amplifiée, d'une boucle de compensation de la tension de décalage comportant: un comparateur, un compteur-décompteur de n bits et un convertisseur numérique/analogique de n bits, dont les sorties complémentaires i1 et i2 (avec i1+i2=i) modulent les courants desdits générateurs de signal, l'amélioration caractérisée en ce que la macro fonctionnelle composée par le convertisseur analogique/ numérique de n bits et le compteur-décompteur de n bits est remplacée par une nouvelle macro fonctionnelle composée de deux convertisseurs numérique-analogique (CNA) de n-1 bits et d'un compteur-décompteur de n bits les convertisseurs étant disposés symétriquement vis-à-vis du compteur-décompteur, et des circuits associés pour assurer que lesdits convertisseurs numérique-analogique fonctionnent de façon complémentaire.

2. Procédé de compensation selon la revendication 1 caractérisé en ce que le premier CNA de n-1 bits est attaqué par les (n-1) sorties $\overline{Q}$ du compteur-décompteur, montées en ET câblé avec la sortie $\overline{Q}$ du MSB, en ce que le deuxième CNA est identique au premier mais comporte cependant une $n^{\text{ième}}$ cellule assurant un LSB supplémentaire, ce CNA est attaqué par les (n-1) sorties Q du compteur-décompteur montées en ET câblé avec la sortie Q du MSB, et ladite $n^{\text{ième}}$ cellule est commandée par la sortie Q du MSB.

3. Procédé de compensation selon la revendication 2 caractérisé en ce que l'ensemble fonctionnel compteur-décompteur plus premier CNA et plus second CNA est réalisé en technologie MTL.

4. Procédé de compensation selon la revendication 3 caractérisé en ce que n=5.

5. Procédé de compensation selon la revendication 4 caractérisé en ce que la sortie $\overline{Q}$ du MSB est obtenue en inversant la sortie Q dans une porte MTL (A) à quatre collecteurs, et que la sortie Q du MSB est obtenue à partir de la sortie $\overline{Q}$ après inversion dans une porte MTL (B) à quatre collecteurs.

6. Procédé de compensation selon l'une des revendications 3 à 5 caractérisé en ce que l'initialisation du compteur à la mise sous tension est réalisée automatiquement grâce à des modifications topologiques des cellules.

7. Procédé de compensation selon la revendication 6 caractérisé en ce que ces différentes modifications sont basées sur des largeurs des bases des PNP latéraux.

8. Procédé de compensation selon la revendication 6 ou 7 caractérisé en ce que l'initialisation du compteur à la mise sous tension est faite à la moitié de la pleine échelle.

9. Procédé de compensation caractérisé en ce que la nouvelle macro fonctionnelle est intégrée monolithiquement.

10. Macro fonctionnelle caractérisée en ce qu'elle comprend un compteur-décompteur de n bits et deux convertisseurs numérique-analogique de n-1 bits munis chacun d'une sortie fournissant respectivement un courant i1 et i2 disposés symétriquement vis-à-vis du compteur-décompteur, et des circuits associés pour assurer que lesdits convertisseurs fonctionnent de manière complémentaire, c'est-à-dire que i1+i2=i, i étant un courant constant prédéterminé.

11. Macro-fonctionnelle selon la revendication 10 caractérisée en ce que les entrées du premier CNA de n-1 bits sont attaquées par les n-1 sorties $\bar{Q}$ (à compteur du LSB) du compteur-décompteur, montées en ET câblé avec la sortie $\bar{Q}$ du MSB, que le deuxième CNA de n-1 bits est identique au premier mais comporte cependant une $n^{ième}$ cellule assurant un LSB supplémentaire, les sorties de ce deuxième CNA sont attaquées par (n-1) les sorties Q du compteur-décompteur, montées en ET câblé avec la sortie Q du MSB et ladite $n^{ième}$ cellule est commandée par la sortie Q du MSB.

12. Macro-fonctionnelle selon la revendication 11 caractérisé en ce que lesdits compteur-décompteur, et les CNA sont réalisés en technologie MTL.

13. Macro-fonctionnelle selon la revendication 12 caractérisée en ce que n=5.

14. Macro-fonctionnelle selon la revendication 13 caractérisée en ce que le premier CNA comporte quatre transistors MTL à quatre collecteurs, les contacts avec les régions base formant les entrées logiques, pour chaque base on associe symétriquement un pavé d'injection, tous les pavés d'injection sont reliés à une tension appropriée sauf, un pavé du premier transistor qui est relié à la masse, la sortie est reliée à un collecteur des premier et second transistors, à deux collecteurs et aux quatre collecteurs des troisième et quatrième transistors respectivement, les collecteurs non utilisés par la correction de sortie sont reliés à une tension d'alimentation appropriée.

15. Macro-fonctionnelle selon la revendication 13 ou 14 caractérisée en ce que la sortie $\bar{Q}$ du MSB est obtenue en inversant la sortie Q dans une porte MTL (A' à

18

0032551

quatre collecteurs et que la sortie Q est obtenue à partir de la sortie $\overline{Q}$ après inversion dans une porte MTL (B) à quatre collecteurs.

0032551

1/4

# FIG. 1

AMPLIFICATEUR DIFFERENTIEL

# FIG. 2

AMPLIFICATEUR DIFFERENTIEL

FILTRE PASSE-BAS

# FIG. 3

AMPLIFICATEUR          AMPLIFICATEUR

# FIG.4

Circuit diagram labels: $V_+$, R1, R2, A, B, $\Delta V$, V+, V−, $V_{OUT}$, AMPLIFICATEUR DIFFERENTIEL, I1, I2, $i_1$, $i_2$, C N/A, n bits, HORL., COMPTEUR DECOMPTEUR, COMPARATEUR, $V_{REF}$

# FIG.6

Circuit diagram labels: $i_1$, CNA 1, A, MSB, HORL., Q, $\bar{Q}$, $\bar{Q}$, LSB, COMPTEUR-DECOMPTEUR 5 BITS, B, C, CNA2, $i_2$

# FIG. 5

$\Delta V$

$0$

TEMPS

$-Ri_2$

$-Ri_2 + \Delta V_0$  $\Delta V_0$

$\Delta V_0$

$V_{OUT}$
$V+$
$V_{SMAX}$
$V_{REF}$
$V_{SMIN}$

$V_-$

HORL.

COMPTAGE       ALTERNANCE       INHIBITION DE L'HORL.

$2^{n-1}$ IMPULSIONS

SORTIE CNA

$i$

$i_2$

$i_{/2}$

$i_1$

SORTIE COMP.

$V_{OUT} < V_{REF}$

$V_{OUT} > V_{REF}$

$\Delta V_0 < 0$       $\Delta V_0 > 0$

FIG. 7

| Catégorie | Citation du document avec indication, en cas de besoin, des parties pertinentes | Revendication concernée |
|---|---|---|
| A | DE - A - 2 742 371 (SIEMENS) <br> * Figure 1a; page 8, ligne 21-26 * <br> -- | 1 |
| A | US - A - 3 934 197 (A. PETTERSON) <br> * Figure 1; abrégé * <br> -- | 1 |
| A | US - A - 3 868 583 (H.F. KRABBE) <br> * Figure 1, abrégé * <br> & FR - A - 2 104 076 <br> -- | 1 |
| A | FR - A - 2 357 110 (T.R.T.) <br> * Figure 1, revendication 1 * <br> -- | 1,2 |
| A | US - A - 4 174 539 (W.C. TIMM) <br> * Figure 1; abrégé * <br> -- | 1 |
| A | US - A - 4 163 244 (L.J. RAYONESE) <br> * Figure 4b; abrégé * <br> -- | 3,12 |
| P | US - A - 4 229 703 (R. BUSTIN) <br> * Figure 2; abrégé * <br> ---- | 1 |

## DOCUMENTS CONSIDERES COMME PERTINENTS

**CLASSEMENT DE LA DEMANDE (Int. Cl.³)**

H 03 F   3/45
G 01 R   17/06

**DOMAINES TECHNIQUES RECHERCHES (Int. Cl.³)**

H 03 F   3/45
          1/30
G 11 C   19/08
G 01 R   17/00
          17/02
          17/06
H 01 L   27/02
H 03 K   13/02

**CATEGORIE DES DOCUMENTS CITES**

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons
&: membre de la même famille, document correspondant

Le présent rapport de recherche a été établi pour toutes les revendications

| Lieu de la recherche | Date d'achèvement de la recherche | Examinateur |
|---|---|---|
| La Haye | 21-04-1981 | MIELKE |